Europäisches Patentamt

(19) European Patent Office

Office européen des brevets

(11) Publication number: **0 139 366**
**B1**

(12) **EUROPEAN PATENT SPECIFICATION**

(45) Date of publication of patent specification: **12.10.88**

(21) Application number: **84305337.2**

(22) Date of filing: **06.08.84**

(51) Int. Cl.⁴: **H 01 L 21/90,** H 01 L 27/14

(54) Method of manufacturing a soldi-state image pickup device.

(30) Priority: **23.08.83 JP 153761/83**

(43) Date of publication of application:
**02.05.85 Bulletin 85/18**

(45) Publication of the grant of the patent:
**12.10.88 Bulletin 88/41**

(84) Designated Contracting States:
**DE FR GB NL**

(56) References cited:
**EP-A-0 012 863**
**EP-A-0 023 079**
**EP-A-0 040 076**

**PATENT ABSTRACTS OF JAPAN vol. 5, no. 121,
5th August 1981, page (E-68) (793); & JP-A-56-
58247 (FUJITSU K.K.) 21-05-1981**

(73) Proprietor: **KABUSHIKI KAISHA TOSHIBA
72, Horikawa-cho Saiwai-ku
Kawasaki-shi Kanagawa-ken 210 (JP)**

(72) Inventor: **Harada, Nozomu Patent Division
Toshiba Corp.
Principal Office 1-1 Shibaura 1-chome
Minato-ku Tokyo (JP)**
Inventor: **Komatsubara, Yoshiaki Patent
Division
Toshiba Corp. Principal Office
1-1 Shibaura 1-chome Minato-ku Tokyo (JP)**

(74) Representative: **Shindler, Nigel et al
BATCHELLOR, KIRK & EYLES 2 Pear Tree Court
Farringdon Road
London EC1R 0DS (GB)**

## Description

This invention relates to a method of manufacturing a solid state image pickup device for use in a photoelectric converter employing a photoconductive film, and more particularly to a method of manufacturing the same having a low dark current and low lag characteristic.

A "two-level" solid state image pickup device is a device having a signal charge read-out portion constituted by a charge coupled device (CCD) formed on a silicon monocrystalline substrate, and a photoelectric conversion portion constituted by a photoconductive film formed on the signal charge read-out portion.

It has many advantages such as increased sensitivity, due to its being able to present a large aperture to incident light, and low blooming.

However, there are problems with the characteristics of such a construction which will be explained below.

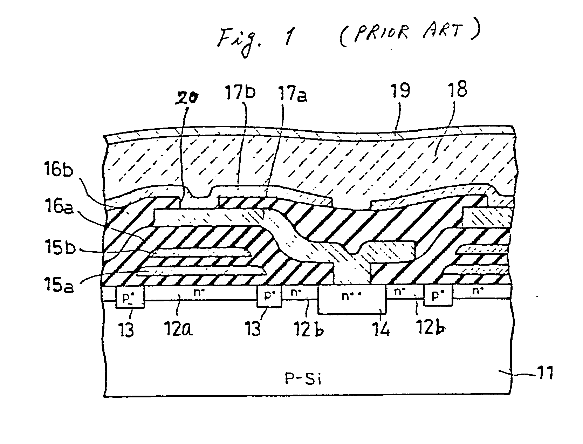

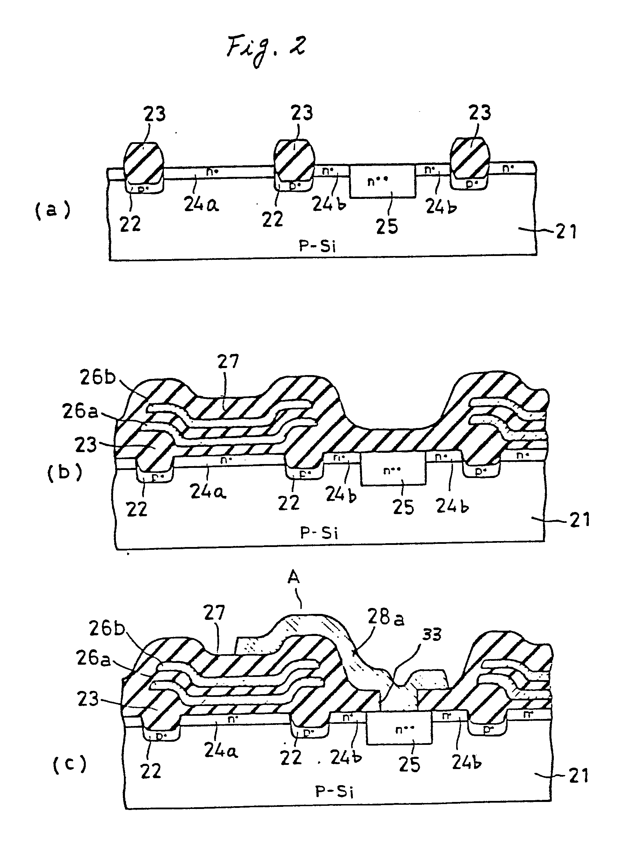

Figure 1 shows a cross-section of a conventional two level solid state image pickup device. Reference numeral 11 is, for example a p-type Si substrate, on the surface of which are provided a first $n^+$ layer 12a providing the CCD channel for read-out of signal charge, a second $n^+$ layer 12b constituting a signal charge accumulation region, an $n^{++}$ layer 14 provided to establish an ohmic connection between this accumulation region 12a and a first metallic electrode 17a formed for example of aluminium (Al), and a channel stopper $p^+$ layer 13. A gate oxide film is formed on top of the CCD channel 12a, and CCD transfer electrodes 15a, 15b are then formed on top of the gate oxide film and are made of for example two layers of polycrystalline silicon. A first insulating film 16a is deposited on top of these two transfer electrode layers 15a and 15b. The first metallic electrode 17a, which is connected to the $n^{++}$ layer 14 through contact holes formed in this insulating film 16a, is arranged to extend over the CCD channel. A second insulating film 16b is then deposited on top of this, and second metallic electrodes 17b formed of aluminium (Al), which comprise pixel electrodes, are provided for each pixel region. These second metallic electrodes 17b are connected to the first metallic electrodes 17a through contact holes 20 provided in the second insulating film 16b. The contact holes 20 are formed by a reactive ion etching of the second insulating film 16b using a patterned photoresist as a mask. On top of the second metallic electrodes 17b, a photoconductive film 18 consisting of for example amorphous Si and a transparent conductive layer provided by an ITO film 19 are formed.

The $n^+$ layer 12b constituting the signal charge accumulation region, $n^{++}$ layer 14, first metallic electrode 17a and second metallic electrode 17b are separately provided for each pixel. That is, the second metallic electrodes 17b define image pickup pixel regions and the potential variations obtained by the second metallic electrodes 17b as a result of the image pickup performed by the photoelectric film 18 are transmitted through the first metallic electrode 17a to the $n^+$ layer 12b constituting the accumulation region, and are accumulated in this region as signal charges. Figure 1 shows the cross-section in which the channel stopper $P^+$ layer 13 can be seen, but transfer regions which transfer the signal charges of the $n^+$ layers 12b to the CCD channel $n^+$ layer 12a are of course provided for each pixel.

In such a solid state image pickup device, the substrate surface before the photoconductive film 18 is formed must be as flat as possible. If it is not flat, this results in appreciable dark current and lag of the solid state image pickup device, with adverse effects on the image pickup characteristic.

The reason for this is that the film quality of the photoconductive film is poorer over substrate surface irregularities as compared with what it is where the substrate surface is smooth, and this increases the numbers of generation and recombination centres, which cause dark current and lag. It is therefore necessary to ensure that the surface of the second insulating film 16b is as flat as possible, and that the contact holes 20 formed in the second insulating film 16b provide a few irregularities as possible.

As example of a structure of this kind is shown in EP—A—00 40 076.

However, in the previous method, wherein the contact holes 20 were formed by reactive ion etching (RIE) using a photoresist mask, the process was complicated by the number of stage required, including forming a photoresist film, patterning the film, and then etching the insulating layer by RIE. Furthermore, in the previous method in which RIE was used, the sides of the contact holes were very steep so if the second metallic electrodes 17b were made thin, breaks in the metallic film become a considerable problem. Therefore, the minimum thickness of the metallic electrodes 17b was limited to approximately 400—500 nm (4000Å—5000Å), and irregularities of the substrate surface could not be minimised.

Accordingly, the present invention seeks to provide a method of manufacturing a two level solid state image pickup device in which the aforementioned problems are solved and which has little dark current or lag.

According to the present invention, part of the first metallic electrode is made to project to the highest position above the substrate on which it is formed, a coating of an organic insulating film is then applied to produce a flat surface, and the entire surface of the organic insulating fim is then etched to expose the projections of the first metallic electrode. The advantage of this is that the contact holes for connecting the second metallic electrodes to the first metallic electrodes are formed automatically without recourse to a photolithographic process.

Some embodiments of the invention will now be described by way of example with reference to the accompanying drawings, wherein:

Figure 1 shows a cross-sectional view of a conventional solid state image pickup device built up of layers and employing a photoconductive film as a photoelectric converter;

Figures 2a to 2f are views showing the manufacturing stages of an embodiment of the present invention;

Figure 3 shows a cross sectional view of another embodiment of the present invention;

Figures 4a and 4b are cross sectional views of another embodiment of the present invention; and

Figure 5 shows a cross sectional view of another embodiment of the present invention.

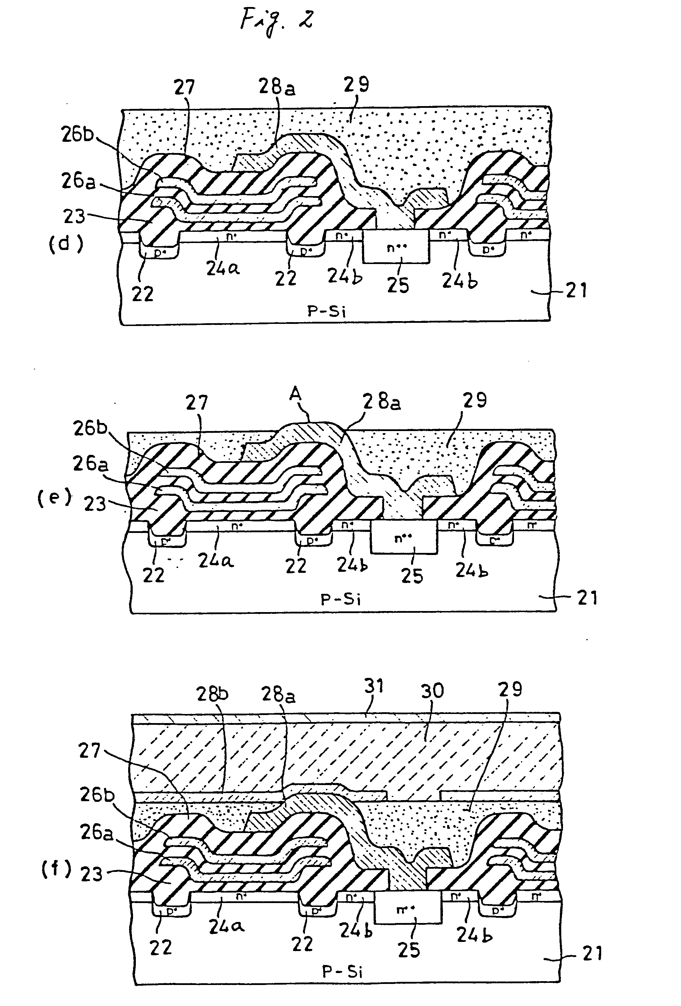

Reference will now be made to the drawings, wherein like reference numerals designate identical or corresponding parts throughout the several views, and more particularly to Figures 2a to 2f thereof, which shows the manufacturing stages of the embodiment according to the present invention.

Figure 2a shows the condition in which $p^+$ layers 22 are formed as channel stopper regions of the p type silicon substrate 21, field oxide films 23 projecting upwards are formed by selective oxidation, the CCD channel $n^+$ layer 24a is formed, signal charge accumulation $n^+$ layers 24b are formed, and an $n^{++}$ layer 25 is formed constituting a contact region for the $n^+$ layer 24b and metallic electrodes.

Next, as shown in Figure 2b, on top of the gate oxide film, CCD transfer electrodes 26a and 26b are formed of polysilicon extending over the field oxide film 23, and the entire surface of the device is covered with a silicon oxide film 27, which is a first insulating film, by chemical vapour deposition (CVD).

The contact holes 33 are then formed, and evaporated of Al and patterning thereof are carried out, so that first metallic electrodes 28a are formed which extend over the CCD channel, contacting the $n^{++}$ layer 25, as shown in Figure 2c.

As can be seen from the drawings, the first metallic electrodes 28a are formed with portions A that project upwards.

A polyimide film 29, which is a second insulating film constituting an organic insulating film is then applied onto the substrate by for example the spin coating process, as shown in Figure 2d. The use of this poyimide film 29 produces a very flat surface. The polyimide film 29 is then fixed by heating for about 30 minutes at the temperature of 400°C—450°C.

Next, the entire surface of the polyimide film 29 is etched by reactive ion etching (RIE) using for example oxygen plasma, and the etching is stopped when the aforesaid projections A of the first metallic electrodes 28a are exposed, as shown in Figure 2a. The completion of the etching process can be easily established by determining the etching time or by detecting reflected light from the first metallic electrode 28a. Contact portions for the first metallic electrodes 28a are therefore formed automatically and without requiring a masking step and in a manner giving a flat surface.

Second metallic electrodes 28b formed of Al are then formed in the same manner as in the conventinal device and the photoconductive film 30 and ITO (transparent organic) film 31 are deposited over the entire surface to complete the device as shown in Figure 2f.

With this embodiment, the first metallic electrode 28a and second metallic electrode 28b can be electrically connected with self-alignment without patterning by photolithography, and the shape of the projection A of the first metallic electrode 28a, which constituted the contact portion, reflects the surface shape of the first insulating film 27.

Therefore, according to the present invention, device manufacture is simplified, and thin second metallic electrodes, the thickness of which is less than 100 nm (1000Å), can be used without any risk of disconnection, so that dark current of the two level solid state image pickup device is reduced and the lag characteristics are much improved.

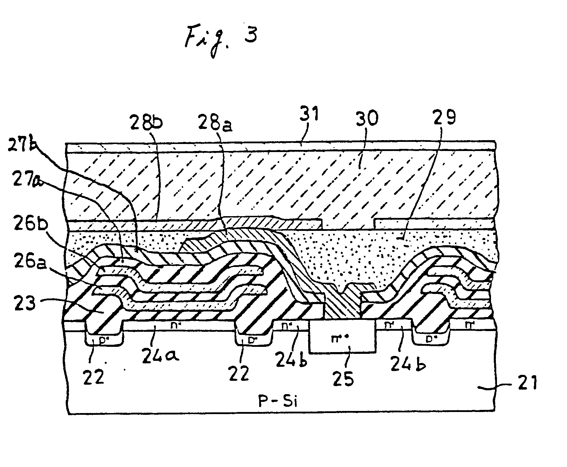

The portion constituted by the oxide film 27 can be replaced by a combination of an oxide film 27a with a phosphor silicate glass (PSG) 27b on top of it, as shown in Figure 3. The PSG layer 27b is then heat treated at for example 1000°C—1100°C to melt the surface thereof. As a result, the projections A become more smooth convexities, and therefore, a continuous smooth connection can be achieved between the projection A and the surface of the polyimide film 29. This enables the second metallic electrode 29b to be made thinner and the overall surface to be made flat, so that the photoconductive film 30 that is formed on this substrate can likewise be deposited in a uniform manner. This results in considerable improvement in respect of the dark current and lag characteristics. Deterioration in sensitivity can also be prevented because the photoconductive film is much more uniform over the surface of the substrate and has few trap levels.

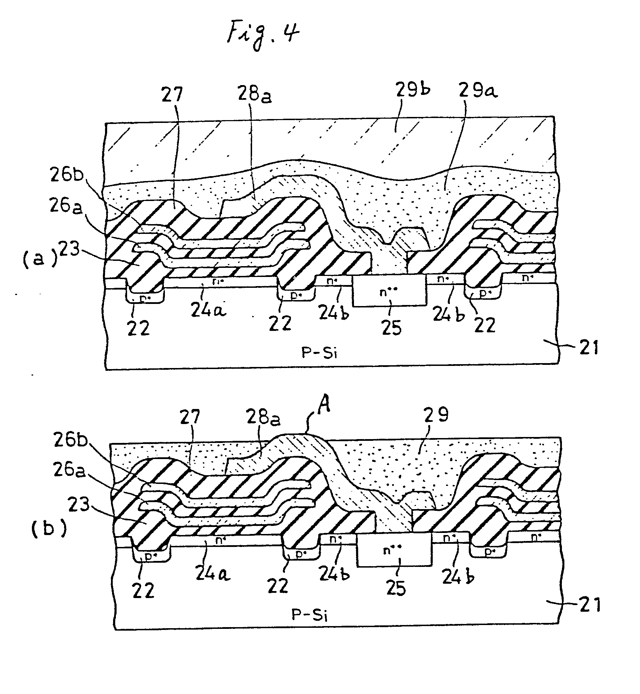

Figures 4a and 4b are given in explanation of another embodiment of the present invention. In the embodiment of Figures 2a to 2f and Figures 3, a flat surface is achieved by application of a thick polyimide film 29, but, when this method is performed using RIE, the inside wall of the reaction vessel becomes very dirty. This does not directly affect the characteristics of the device, but cleaning of the inner wall of the reaction vessel is very laborious, while if it is left dirty problems arise when RIE is next carried out.

Accordingly, in this embodiment a two stage process is performed, in which the flatness shown in Figure 2d is achieved by first of all depositing a relatively thin polyimide film 29a sufficient to cover the projections A of the first metallic electrode 28a, then applying a photoresist film 29b into its surface, as shown in Figure 4a.

The whole surface is then etched by RIE as in the preceding embodiments, to expose the projections A of the second metallic electrode 28a, as shown in Figure 4b.

This procedure involving RIE of a photoresist has been found effective in reducing soiling of the inside wall of the reactive vessel.

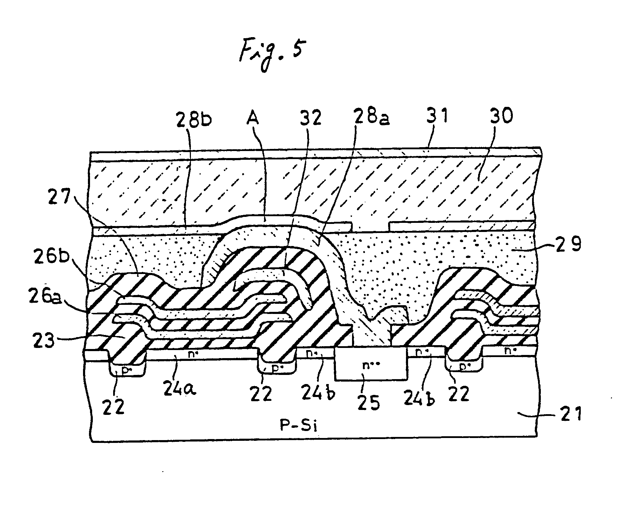

Figure 5 shows yet a further embodiment of the present invention. It differs from Figure 2 in that a buried electrode 32 consisting of a third polysilicon layer is formed in the oxide film 27 between the transfer electrodes 26a and 26b and first metallic electrode 28a on the channel stopper $p^+$ layer 22. This buried electode 32 is earthed or has a DC voltage applied to it and provides electrostatic shielding between the transfer electrodes 26a and 26b and the first metallic electrode 28a.

Since in this embodiment the additional, third polysilicon layer constituting the buried electrode 32 is provided underneath the projections A, the projections A project further above than the rest of the surface. This facilitates the process of exposing only these projections.

This electrostatic shielding also has the effect of preventing deterioration of the lag characteristics or unstable operation. Specifically, the storage diode constituted by the $n^{++}$ layer 25 and p type substrate 21, that is connected to the first metallic electrode 28a is in a electrically floating condition during the period for which the signal charge is stored, so application of the clock pulse to the transfer electrodes 26a and 26b causes capacitative variation of the potential of the $n^{++}$ layer 25. This results in some of the signal charge that has reached this $n^{++}$ layer 25 being returned to the photoconductive film, causing deterioration of the lag characteristics and operational instability such as flickering. The electrostatic shielding effect of the buried electrode 32 of this embodiment is effective in preventing such adverse effects on the characteristics.

Polysilicon was used as the material of the CCD transfer electrodes and buried electrode in the above description but other conductive materials such as molybdenum (Mo), molybdenum silicide (Mo-Si) or tungsten (W) could be used.

The etching of the polyimide film 29 was performed by reactive ion etching using oxygen plasma, but other methods such as chemical etching using hydrazine solution could be used provided they produce uniform etching of the entire surface. Other organic insulating materials instead of the polyimide film 29 could be used, such as for example rubbery or acrylic macromolecular films.

The above description concerns mainly the effective sensitive region of the solid state image pickup device. If the metallic electrodes in the region of the bonding pad that is provided around the edges of the element for external connections are left exposed at the same time as the first metallic electrodes 28a are exposed, it is not necessary to carry out patterning by photolithography on the bonding pad.

The above description assumes the use of a CCD substrate, but substrates having other means of enabling read-out of the signal charge generated by photoconductive film could be used.

## Claims

1. A method of manufacturing a solid state image pickup device including the steps of:

(a) forming on a semiconductor substrate (21), a signal storage region (24a, 24b) for each pixel, and corresponding signal charge read-out regions (25);

(b) depositing a first insulating film (23) on the signal storage regions and signal read-out regions;

(c) forming contact holes in the first insulating film;

(d) forming first metallic electrodes (28a) on the first insulating film so as to make electrical connections to the signal storage regions through the contact holes;

(e) depositing a second insulating film (29) and forming contact holes in the said second insulating film;

(f) forming second metallic electrodes (28b) constituting the pixel electrodes to be connected to the first metallic electrodes through the contact holes; and

(g) depositing a photoconductive film (30) over the whole surface and forming a transparent conductive layer (31) on the photoconductive film;

characterised in that the first metallic electrodes (28a) are formed with upward projections (A) reflecting the surface shape of the first insulating film (23), at the highest position above the semiconductor substrate (21), the second insulating film is an organic insulating film which is formed with a substantially flat top surface covering said projections (A), and the contact holes in the second insulating film are formed by etching away the entire surface of said film until the said projections are exposed.

2. A method of manufacturing a solid state image pickup device according to claim 1, wherein the material of said organic insulating film (29) is polyimide and a single layer of the polyimide film is applied to produce a flat surface.

3. A method of manufacturing a solid state image pickup device according to claim 1, wherein said second insulating film (29) is a film consisting of a combination of a polyimide film (29a) and a photoresist film (29b), said polyimide film (29a) being applied so as to cover the projections of said first metallic electrodes, and said photoresist fim then being applied to produce a flat surface.

4. A method of manufacturing a solid state image pickup device according to any preceding claim further including the step of selectively burying an electrically insulated conductive electrode (32) under the projections of said first metallic electrodes.

5. A method of manufacturing a solid state image pickup device according to any preceding claim, wherein said first insulating film (27) includes a field oxide film (23) projecting upwards in conformity with the shape of the projections of said first metallic electrodes (28a).

6. A method of manufacturing a solid state image pickup device according to any preceding claim wherein said signal read-out regions (24a, 26a, 26b) comprise charge coupled devices.

7. A method of manufacturing a solid state image pickup device according to any preceding claim, wherein said photoconductive film (30) consists of amorphous silicon.

8. A solid state image pickup device with a substantially uniform and flat photoconductive film produced by the method of any preceding claim.

## Patentansprüche

1. Verfahren zur Fertigung einer Halbleiterbildaufnahmeeinrichtung, mit folgenden Schritten:

(a) Herstellung eines Halbleitersubstrats (21), eines Signalspeicherbereichs (24a, 24b) für jedes Pixel, und von entsprechenden Signalladungslesebereichen (25),

(b) Aufbringung eines ersten, isolierenden Films (23) auf den Signalspeicherbereichen und Signallesebereichen,

(c) Herstellung von Kontaktlöchern in dem ersten isolierenden Film,

(d) Herstellung erster metallischer Elektroden (28a) auf dem ersten isolierenden Film, um so elektrische Verbindungen zu den Signalspeicherbereichen durch die Kontaktlöcher herzustellen,

(e) Aufbringung eines zweiten isolierenden Films (29) und Herstellung von Kontaktlöchern in dem genannten zweiten isolierenden Film,

(f) Herstellung zweiter metallischer Elektroden (28b) zur Verbindung der Pixelelektroden mit den ersten metallischen Elektroden durch die Kontaktlöcher, und

(g) Aufbringung eines fotoleitenden Films (30) über die gesamte Oberfläche und Herstellung einer transparenten, leitfähigen Schicht (31) auf dem fotoleitenden Film,

dadurch gekennzeichnet, daß die ersten metallischen Elektroden (28a) an der höchsten Position oberhalb des Halbleitersubstrats (21) mit die Oberflächenform des ersten isolierenden Films (23) wiedergebenden, aufwärts gerichteten Vorsprüngen (A) versehen werden, daß der zeite isolierende Film ein organischer isolierender Film ist, der eine im wesentlichen flache Oberfläche aufweist und die Vosprünge (A) überdeckt, und daß die Kontaktlöcher in dem zweiten isolierenden Film durch Wegätzen der gesamten Oberfläche des Films gebildet werden, bis die genannten Vorsprünge freiliegen.

2. Verfahren nach Anspruch 1, dadurch gekennzeichnet, daß das Material des genannten organischen, isolierenden Films (29) Polyimid ist und daß eine einzelne Schicht des Polyimidfilms aufgebracht wird, um eine flache Oberfläche zu erzeugen.

3. Verfahren nach Anspruch 1, dadurch gekennzeichnet, daß der genannte zweite isolierende Film (29) ein Film ist, der aus einer Kombination aus einem Polyimidfilm (29a) und einem Fotowiderstandsfilm (29b) ist, wobei der Polyimidfilm (29a) so aufgebracht ist, daß er die Vorsprünge der genannten ersten metallischen Elektroden überdeckt, und daß der genannte Fotowiderstandsfilm dann aufgebracht wird, um eine flache Oberfläche zu erzeugen.

4. Verfahren nach einem der vorhergehenden Ansprüche, dadurch gekennzeichnet, daß selektiv eine elektrisch isolierte, leitende Elektrode (32) unter den vorsprüngen der genannten ersten metallischen Elektroden vergraben wird.

5. Verfahren nach einem der vorhergehenden Ansprüche, dadurch gekennzeichnet, daß der genannte erste isolierende Film (27) einen Feldoxidfilm (23) aufweist, der sich nach oben von vorn zur Form der Vorsprünge der ersten metallischen Elektroden (28a) erstreckt.

6. Verfahren nach einem der vorhergehenden Ansprüche, dadurch gekennzeichnet, daß die Signallesebereiche (24a, 26a, 26b) ladungsgekoppelte Einrichtungen aufweisen.

7. Verfahren nach einem der vorhergehenden Ansprüche, dadurch gekennzeichnet, daß der fotoleitende Film (30) aus amorphem Silizium besteht.

8. Halbleiterbildaufnahmeeinrichtung mit einem im wesentlichen gleichförmigen und flachen, fotoleitenden Film, der nach dem Verfahren nach einem der vorhergehenden Ansprüche hergestellt ist.

## Revendications

1. Procédé pour fabriquer un dispositif de prise de vues semi-conducteur qui consiste:

a) à former sur un substrat semi-conducteur (21) une région de conservation de signaux (24a, 24b) pour chaque pixel, et des régions de lecture de charges-signaux (25) correspondantes;

b) à déposer une première pellicule isolante (23) sur les régions de conservation et les régions de lecture de signaux;

c) à former des trous de contact dans la première pellicule isolante;

d) à former des premières électrodes métalliques (28a) sur la première pellicule isolante afin d'établir des connexions électrique avec les régions de conservation de signaux à travers les trous de contact;

e) à déposer une seconde pellicule isolante (29) et à former des trous de contact dans ladite seconde pellicule isolante;

f) à fomer des secondes électrodes métalliques (28b) constituant les électrodes appelées à être connectées aux premières électrodes métalliques à travers les trous de contact; et

g) à déposer une pellicule photoconductrice (30) sur toute la surface et à former une couche conductrice transparente (31) sur la pellicule photoconductrice, caractérisé en ce que les pemières électrodes métalliques (28a) sont formées avec des éléments saillants dressés (A) représentant la forme de la surface de la première pellicule isolante (23), à la position la plus élevée au-dessus du substrat semi-conducteur (21), la seconde pellicule isolante étant une pellicule

organique qui est formée avec une surface pratiquement plate ou plane couvrant lesdits éléments saillants (A), et en ce que les trous de contact sont formés dans la seconde pellicule isolante en enlevant par décapage chimique toute la surface de ladite pellicule jusqu'à ce que lesdits éléments saillants soiente dénudés.

2. Procédé pour fabriquer un dispositif de prise de vues semi-conducteur selon la revendication 1, caractérisé en ce que la matière constituant ladite pellicule isolante (29) est un polymide et en ce qu'on n'applique qu'une seule couche de polyimide afin de produire une surface plate ou plane.

3. Procédé pour fabriquer un dispositif de prise de vues semi-conducteur selon la revendication 1, caractérisé en ce que la seconde pellicule isolante (29) est une pellicule résultant de la combinaison d'une pellicule de polyimide (29a) et d'une pellicule de résine photosensible (29b) et en ce qu'on applique ladite pellicule de polyimide (29a) de manière à couvrir les éléments saillants desdites premières électrodes, avant d'appliquer ladite pellicule de résine photosensible pour produire une surface plate un plane.

4. Procédé pour fabriquer un dispositif de prise de vues semi-conducteur selon l'une quelconque des revendications précédentes, caractérisé en ce qu'il inclut aussi une étape consistant à "enterrer" ou à noyer une électrode conductrice isolée du point de vue électrique (32) sous les éléments saillants desdites premières électrodes métalliques.

5. Procédé pour fabriquer un dispositif de prise de vues semi-conducteur selon l'une quelconque des revendications précédentes, caractérisé en ce que ladite première pellicule isolante (27) comprend une pellicule d'oxyde (23) qui s'élève en épousant la forme des éléments saillants desdites premières électrodes métalliques (28a).

6. Procédé pour fabriquer un dispositif de prise de vues semi-conducteur selon l'une quelconque des revendications précédentes, caractérisé en ce que lesdites régions de lecture de signaux (24a, 26a, 26b) comprennent des dispositifs à couplage de charge.

7. Procédé pour fabriquer un dispositif de prise de vues semi-conducteur selon l'une quelconque des revendications précédentes, caractérisé en ce que la pellicule photoconductrice (30) est en silicium amorphe.

8. A titre de produite industriel nouveau, un dispositif de prise de vues semi-conducteur comportant une pellicule photoconductrice pratiquement uniforme et plate ou plane fabriqué par le procédé spécifié dans l'une quelconque des revendications précédentes.

Fig. 1 (PRIOR ART)

## Fig. 2

(a)

(b)

(c)

Fig. 2

(d)

27　28a　29

26b
26a
23

26b

p⁺ 22　24a　n⁺ 22　n⁺ 24b　n⁺⁺ 25　24b　21

P-Si

(e)

27　A　28a　29

26b
26a
23

22　24a　22　24b　25　24b

P-Si　21

(f)

28b　28a　31　30　29

27
26b
26a
23

22　24a　n⁺ 22　24b　m⁺ 25　n⁺ 24b　21

P-Si

3

# Fig. 3

Fig. 4

# Fig. 5